(19) Europäisches Patentamt

European Patent Office

Office européen des brevets

(11) **EP 4 521 132 A1**

(12) **EUROPEAN PATENT APPLICATION**

(43) Date of publication:
**12.03.2025 Bulletin 2025/11**

(21) Application number: 23306480.7

(22) Date of filing: **06.09.2023**

(51) International Patent Classification (IPC):
**G01R 31/42** (2006.01)

(52) Cooperative Patent Classification (CPC):
**G01R 31/42**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **NXP B.V.**
**5656 AG Eindhoven (NL)**

(72) Inventors:
• **Vignasse, Baptiste François Jean**
**31023 Toulouse (FR)**
• **Troudi, Rami**
**31023 Toulouse (FR)**

(74) Representative: **Schmütz, Christian Klaus Johannes**
**NXP Semiconductors Germany GmbH**
**Intellectual Property Group**
**Beiersdorfstr. 12**
**22529 Hamburg (DE)**

(54) **MEASUREMENT APPARATUS**

(57)     A measurement apparatus comprising: an input configured to receive current measurements for each phase of a plurality of phases output by an inverter; and an estimator block configured to receive the current measurements at a first time; and receive at least two inverter control signals for control of the output of the inverter at the first time; and calculate an disturbance-estimation using an Unknown Input Observer, UIO, method; and a comparison block configured to receive the current measurement for each phase at a future, second time; and identify which of the plurality of phases is experiencing a measurement failure in the current measurement for that phase based on the current measurements for each phase at the second time and the disturbance-estimation.

Figure 2

# EP 4 521 132 A1

**Description**

**Field**

The present disclosure relates to a measurement apparatus and, in particular, to a measurement apparatus configured to detect measurement failures. It also relates to a system including the measurement apparatus, current sensors and an inverter.

**Background**

The detection of measurement failures in the measurement of current flowing in a plurality of phases of a multi-phase system presents a challenge.

**Summary**

According to a first aspect of the present disclosure there is provided a measurement apparatus comprising:

an input configured to receive current measurements for each phase of a plurality of phases output by an inverter; and an estimator block configured to:

receive the current measurement for each phase at a first time;
receive at least two inverter control signals that are for control of the output of the inverter at the first time;
calculate an disturbance-estimation indicative of the impact of a measurement failure on the current measurements for each phase, the disturbance-estimation based on the current measurement for each phase at the first time and the at least two inverter control signals and calculated using an Unknown Input Observer, UIO, method; and

a comparison block configured to:

receive the current measurement for each phase at a future, second time;
identify which of the plurality of phases is experiencing a measurement failure in the current measurement for that phase based on the current measurements for each phase at the second time and the disturbance-estimation.

In one or more embodiments, the measurement apparatus is configured to determine a sum of the current measurement for each phase at the second time and said identification of which of the plurality of phases is experiencing the measurement failure is provided in response to a determination that said sum is not equal to zero.

In one or more embodiments, the measurement apparatus is configured to operate with a control block, the control block configured to generate the at least two control signals to control one or both of the inverter and a motor that is powered by the plurality of phases output by the inverter, wherein said control signals are based at least in part on the current measurements for each phase, and
wherein the measurement apparatus is configured to, in response to said identification of which of the plurality of phases is experiencing the measurement failure, provide the control block with instructions to ignore the current measurement of the phase that is experiencing the measurement failure in generation of the control signals.

In one or more embodiments, the measurement apparatus is configured to provide a predicted current measurement to the control block to substitute the current measurement for the phase that is experiencing the measurement failure, the predicted current measurement determined based, at least in part, on the current measurements for each phase not experiencing the measurement failure.

In one or more embodiments, said identification of which of the plurality of phases is experiencing a measurement failure comprises the comparison block being configured to calculate a disturbance-function, comprising a function of each phase and using the UIO method, based on the current measurements for each phase at the second time, compare the disturbance-function to the disturbance-estimation, which includes components for each phase, and, based on a difference between the disturbance-function and the disturbance-estimation being greater than a threshold, identify the phase experiencing the measurement failure.

In one or more embodiments, the disturbance-estimation $\dot{\hat{d}}(t)$ is calculated by:

$$\dot{\hat{d}}(t) = inv(C.D).(\dot{y}(t) - C.A.\hat{x}(t) - C.B.u(t))$$

2

wherein C is an observation matrix, A, B and D are matrices that model a system comprising the invertor and a control block that provides the at least two inverter control signals, $\dot{y}(t)$ is a derivative of the output of the system, and $\hat{x}(t)$ is the estimated state vector of the system and $u(t)$ is an input vector based on the inverter control signals.

In one or more embodiments, the measurement apparatus includes a plurality of current sensors, wherein the current measurement for each phase of the plurality of phases output by the inverter is provided by the plurality of current sensors each current sensor associated with a corresponding phase of the plurality of phases output by the inverter.

In one or more embodiments, the comparison module is configured to, based on an empirical mode decomposition of the difference, determine one or more harmonics to identify which current measurement is providing an incorrect measurement.

In one or more embodiments, the comparison block is further configured to analyse the harmonics to determine a failure type associated with the current sensor of the plurality of current sensors associated with the phase of the inverter that is experiencing the measurement failure.

In one or more embodiments, the failure type is one or more of:

noise fault, signal loss fault, offset failure, gain failure, drift failure or a delay failure.

In one or more embodiments, the at least two inverter control signals for control of the output of the inverter comprise one of direct-quadrature-zero signals or $\alpha,\beta$ control signals of a Clark transformation.

In one or more embodiments, said measurement failure is indicative of a failure in one or more of said current sensors.

According to a second aspect of the present disclosure there is provided a system comprising the measurement apparatus of the first aspect, the inverter, and a control block for controlling the invertor.

According to a third aspect of the present disclosure there is provided a method for determining which of a plurality current measurements of a corresponding plurality of phases output by an inverter is experiencing a measurement failure, the method comprising:

receiving current measurements for each phase of a plurality of phases output by an inverter at a first time;
receiving at least two inverter control signals that are for control of the output of the inverter at the first time;
calculating a disturbance-estimation indicative of the impact of a measurement failure on the current measurements for each phase, the disturbance-estimation based on the current measurement for each phase at the first time and the at least two inverter control signals and calculated using an Unknown Input Observer, UIO, method; and
receiving the current measurement for each phase at a future, second time;
identifying which of the plurality of phases is experiencing a measurement failure in the current measurement for that phase based on the current measurements for each phase at the second time and the disturbance-estimation.

In one or more embodiments, the method includes determining a difference between a disturbance function of the UIO method, based on the current measurements, and the disturbance-estimation of the UIO method.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows an example embodiment of a measurement apparatus coupled to a multi-phase inverter system for controlling the operation of an electric motor;
Figure 2 shows an example embodiment of the measurement apparatus showing the components within the measurement apparatus coupled to the multi-phase inverter system; and
Figure 3 shows an example representation of an Unknown Input Observer Module.

## Detailed Description

The control of an inverter that provides a multi-phase output may include the measurement of the current for each of the phases output by said inverter.

The proposed measurement apparatus provides a technique to distinguish faulty current measurements from the multiple current measurements of the output of the inverter. In some examples, the inverter may be a three-phase inverter. For convenience the phases may be referred to as A, B and C. In other examples, the inverter may have more phases, such as six phases or any other number of phases as is known to the skilled person.

The approach may be used to determine a fault in the inverter or a fault in a current sensor that obtains the measurement of the current of the phase. Determining a faulty sensor can allow for improved safety and better control of the system to which such sensors are applied. The ability to identify faults in the measurement of the current of a particular phase may, in one or more examples, allow for continued operation rather than disabling the system when a fault is detected.

It will be appreciated that in some examples, the described measurement apparatus may form part of a larger system in which a fault in the output of the inverter may be detected by alternative means and will be remedied by the provision of an appropriate response to ensure the safety and reliability of the overall system is maintained.

In general, it is desirable to maintain operation of a component (i.e. a motor) coupled to the output of a multi-phase inverter even when the output of one of the current sensors is faulty. This is in contrast with known methods whereby detection of a fault results in disabling the entire system, which can be inconvenient. An object of the claimed apparatus may be to allow such continued operation by, for example, identifying the faulty current sensor and ignoring the output of the faulty current sensor and thus allowing continued operation based on the output of the remaining operational sensors.

The proposed measurement apparatus is exemplified herein as applied to a three-phase system for simplicity, but it will be appreciated that the measurement apparatus can equally be applied to any multi-phase system. The proposed measurement apparatus may be particularly beneficial for use in systems where the multiple phases of the inverter are distributed equally, for instance in the case of a three phase system each of the three phases may be offset by 120 degrees and for a 6 phase system may be offset by 60 degrees, etc.

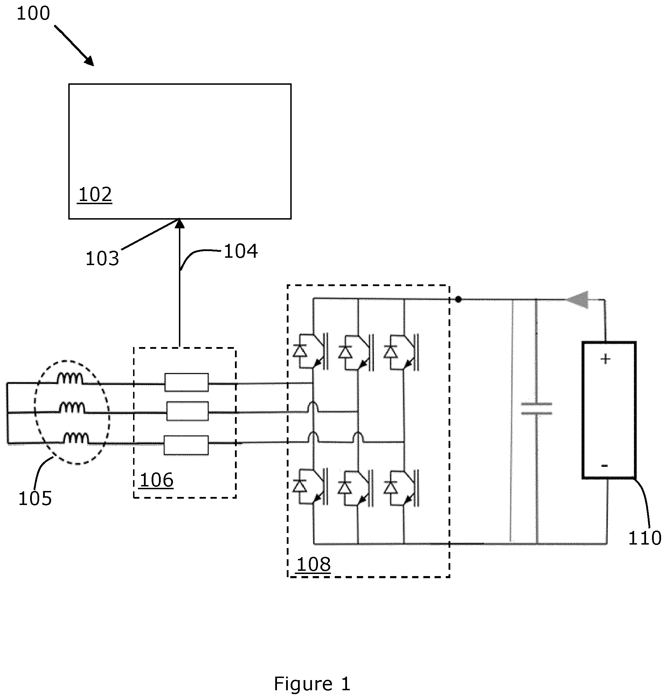

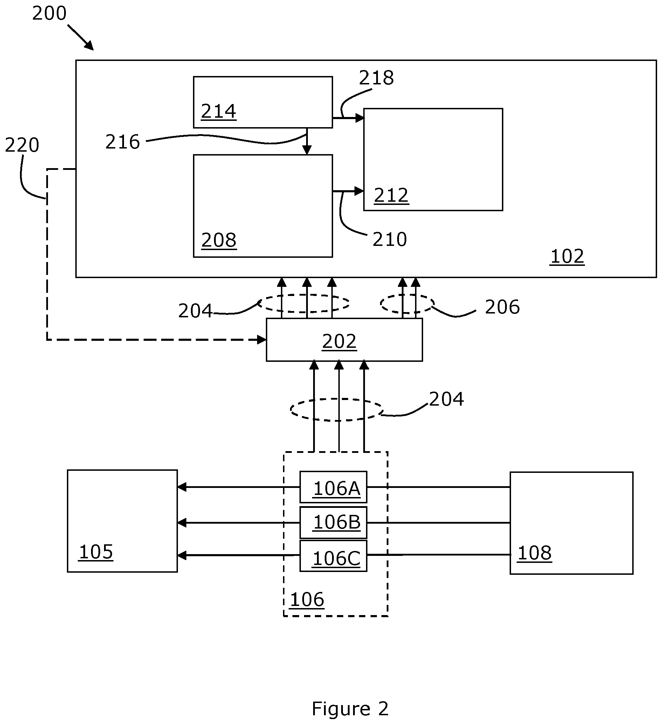

Figure 1 and figure 2 show a system 100, 200 comprising a measurement apparatus 102 for monitoring the current measurements 104, 204 obtained by current sensing circuitry 106 such as a plurality of current sensors 106A-C. The system 100 may further comprise an inverter 108 and a motor 105 powered by the multi-phase output of the inverter 108.

The measurement apparatus 102 comprises an input 103 configured to receive current measurements 104, 204 for each phase of a plurality of phases output by the inverter 108.

The measurement apparatus 102 includes an estimator block 208 that is configured to receive the current measurement 104, 204 for each phase at a first time. The estimator block 208 further receives at least two inverter control signals 206 that are used for control of the output of the inverter 108 at the first time. It will be appreciated that in some examples the at least two inverter control signals 206 may comprise a torque request or a speed request or other request to cause the inverter 108 to alter its output to allow for desired operation of the motor 105. In some examples, the at least two inverter control signals 206 for control of the output of the inverter 108 may comprise one of direct-quadrature-zero signals or $\alpha,\beta$ control signals of a Clark transformation, as will be familiar to those skilled in multi-phase invertor control.

The current measurement 104, 204 for each phase at a first time together with the at least two inverter control signals 206 can be used to determine the expected output current for each phase of the inverter 108 at any subsequent point in time. Accordingly, the expected output current that is determined can be used as a reference value to which the acquired current measurements can be compared at the subsequent point in time.

The estimator block 208 is configured to calculate a disturbance-estimation indicative of the impact of a measurement failure on the current measurements 104, 204 for each phase. The disturbance-estimation is based on the current measurement 104, 204 for each phase at the first time and the at least two inverter control signals 206 and is calculated using an Unknown Input Observer (UIO) method.

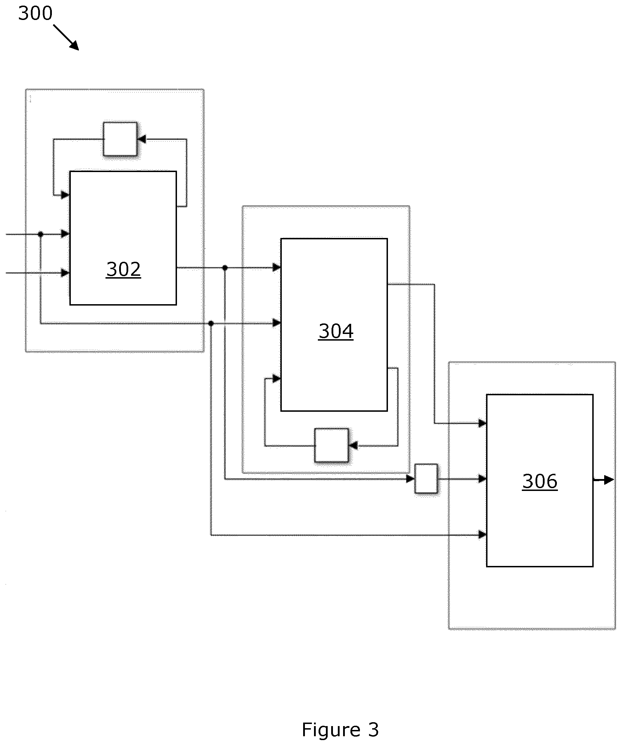

The UIO method is a known methodology in signal processing and is shown schematically in figure 3. Figure 3 shows a representation of the UIO method split into three blocks: the system block 302, the observer block 304 and the system inversion block 306. The UIO method is used to calculate the disturbance-estimation based on the measurable parameters, such as the measured current. The calculated disturbance-estimation value is then compared to the actual state of the system to determine whether a fault has been detected.

The observer of the UIO method is modelled as follows:

$$\dot{z}(t) = N.z(t) + G.u(t) + L.y(t) \qquad (1)$$

$$\hat{x}(t) = z(t) + H.y(t) \qquad (2)$$

Where N, G, L and H are each a matrix defined to model the observer based on the system 100. In this example the system 100 comprises the motor control hardware and software. However in other examples the system include other types of devices coupled to an inverter output. $z(t)$ is a state vector representing the state of the observer. $\dot{z}(t)$ is the derivative of $z(t)$. $u(t)$ is the input vector, which in one or more examples, represents the inverter control signals 206, i.e. the torque request for the inverter 108/motor 105. $\hat{x}(t)$ is the estimated state vector of the system, determined by the observer block 304. $y(t)$ is the output of the system, in this example the output of the system includes the current measurements 104, 204 from the current sensors 106A-C.

The system inversion block 306 in figure 3 determines $\hat{x}(t)$, which is an estimate of the state vector due to the impact of a failure of any of the current sensors 106A-C.

The measurement apparatus 100 is configured to model the system (e.g. the inverter 108, control block 202 that provides the inverter control signals and motor 105) as such:

$$\dot{x}(t) = A.x(t) + B.u(t) + F.d(t) \qquad (3)$$

$$y(t) = C.x(t) \qquad (4)$$

Where A, B, F and C are matrices defined to model the system with C being the observation matrix, and wherein $d(t)$ is a disturbance-function representing the actual state of the system in terms of disturbance. $x(t)$ is the state vector of the system when the system has no fault.

Considering the system is a closed loop, any failure on the current measurements (on y(t)) will propagate through to u(t). The failure will then be considered as a change in the disturbance-function d(t), and the role of the observer will be to determine the disturbance-estimate (i.e. $\hat{d}(t)$).

$$\dot{\hat{d}}(t) = inv(C.D).(\dot{y}(t) - C.A.\hat{x}(t) - C.B.u(t)) \qquad (5)$$

Wherein D is a further matrix that models the system.

To determine whether a fault exists, the following equation is considered:

$$e(t) = d(t) - \hat{d}(t) \qquad (3)$$

Wherein $d(t)$ is the disturbance-function representing the actual state of the system at the second time for comparison with the disturbance-estimation, $\hat{d}(t)$. $d(t)$, as mentioned, is determined by modelling (i.e. calibration) the system, which may include, in the present example, the motor control hardware and software, such as the control block 202 that provides the inverter control signals 206.

When there is no failure, $e(t)$ is equal to or close to zero. This indicates that there are no faults in the current measurements 104, 204. As such it can be assumed that the current sensors 106A-C are functioning. When a failure occurs in the system 100, e(t) is not equal to, or within a threshold value of, zero. This assessment can be used to signify the presence of a fault.

The functions $d(t)$ and $\hat{d}(t)$ may be formulated as functions of the phases. Thus, in some examples, identification of which of the plurality of phases is experiencing a measurement failure comprises the comparison block 212 being configured to calculate the disturbance-function based on the current measurements 204 for each phase at the second time, compare the disturbance-function $d(t)$ to the disturbance-estimation $\hat{d}(t)$ 210 and, based on a difference between the disturbance-function and the disturbance-estimation 210 for a particular phase of the function being greater than a threshold, identify the phase experiencing the measurement failure. The disturbance function may be considered to represent the expected disturbance in the system. Usually unknown observer modelling is used to decrease the disturbance in order to increase the efficiency of the system, however, in the present examples, it will be appreciated by those skilled in the art that the failure will create a variation in the difference $d(t) - \hat{d}(t)$. Thus, the disturbance is used to identify the fault. The measurement apparatus may be configured to provide an empirical mode decomposition (EMD) that can be used to decompose this "difference" $e(t)$ into harmonics and identify which current measurement (a, b or c) has been failing, as described below.

Thus, to summarise, the solution proposed is based on use of the Unknown Input Observer method to determine the occurrence of a faulty current measurement. The disturbance function $d(t)$ and the disturbance-estimation $\hat{d}(t)$ are functions of the each phase and therefore the $e(t)$ is also indicative of the faulty phase. The disclosure also relates, optionally, to the study of the harmonic signature of the unknown perturbation generated by the faulty current measurement.

The disturbance-estimate ($\hat{d}$) includes components for each phase, which we will term $\left(\widehat{d_a}\right), \left(\widehat{d_b}\right), \left(\widehat{d_c}\right)$. Thus, determination of the disturbance-estimate ($\hat{d}$) includes determination of the disturbance-estimate for each current measurement 204 (i.e. for each phase current $I_A$, $I_B$ and $I_C$). In particular:

the disturbance-estimate due to failure in $I_A$ is based on ( $\widehat{d_a}$ );

the disturbance-estimate due to failure in $I_B$ is based on ( $\widehat{d_b}$ ); and

the disturbance-estimate due to failure in $I_C$ is based on ( $\widehat{d_c}$ );

It will be appreciated that the impact on any current measurement sensor 106A-C shall be seen on its respective per phase disturbance-estimate $(\widehat{d_a}), (\widehat{d_b}), (\widehat{d_c})$. This technique can therefore provide a distinction between healthy and faulty current sensors.

The identification of the type of failure in each current measurement 104, 204 may be determined by the comparison module 212 by analysing $(\widehat{d_a}), (\widehat{d_b}), (\widehat{d_c})$. The impact of each type of failure, i.e., drift, offset, noise and delay can be determined by using this technique.

Returning now to figure 1, the measurement apparatus 102 includes a comparison block 212 configured to receive the current measurement 104, 204 for each phase at a future, second time and identify which of the plurality of phases is experiencing a measurement failure in the current measurement 104, 204 for that phase based on the current measurements for each phase at the second time (represented by the disturbance-function $d(t)$ in some examples) and the disturbance-estimation (e.g. represented as $\hat{d}(t)$ above and which includes components for each phase) 210.

It will be appreciated that in some examples the failure determined by the measurement apparatus 102 can be treated as failure of the three-phase inverter 108 or a failure in the current sensing circuitry 106. The example embodiments described in this application relate to determining a failure of the current sensing circuitry 106, and in particular the failure of one of the current sensors 106A-C within the current sensing circuitry 106 itself. However, the approach described can also be applied to determining a faulty output of the inverter 108.

An advantage of identifying which sensor 106 A-C of the current sensing circuitry 106 is providing a faulty measurement can, in one or more embodiments, allow for continued control of the inverter 108 based on the remaining accurate current measurements 104, 204. This can allow for continued accurate and safe operation of devices (such as a motor 105) coupled to the output of the multi-phase inverter 108. In some examples, the device may comprise a vehicle in which the motor 105 may be used and the continued control can allow for said vehicle to continue to be operated safely even when the current sensing circuitry 106 develops a fault.

The example of figure 2, further shows a calculation block 214 which may be part of the measurement apparatus 102. The calculation block 214 is configured to determine a sum of the current measurements 204 for each phase at the second time. In normal operating conditions the sum of the output currents from the multiphase inverter 108 should sum to zero at any given time (based on the phase relationship of the output currents). If the sum of the currents does not equal zero, the calculation block 214 can raise a flag 216 indicating that the current sensing circuitry 106 has failed. Whilst the calculation block 214 cannot determine which phase is experiencing a failure, the operation of the comparison block 212 may be conditional on the determination of a non-zero calculation performed by the calculation block 214. Thus, if the sum of the output currents at any given time is equal to zero, then it can be assumed that there is no error in the current sensing circuitry 106, 106A-C. This will allow the system 100, 200 to only require operation of the comparison block 212 when the flag 216 is raised thus avoiding unnecessary processing.

Figure 2 further shows the measurement apparatus 102 as being configured to operate with a control block 202. The control block 202 can be configured to generate the control signals 206 to control one or both of the inverter 108 or the motor 105 that is powered by the plurality of output phases of the inverter 108. It will be appreciated that the control signals 206 are based at least in part on the current measurements 204 for each phase of the output of the inverter 108. In some examples, the measurement apparatus 102 is configured to, in response to said identification of which of the plurality of phases is experiencing the measurement failure, provide the control block 202 with instructions 220 to ignore the current measurement that is experiencing the measurement failure in generation of the control signals 206. This may allows for continued operation of the motor by using the output of the remaining functional sensors in the current measurement circuitry 106 and the control signals 206 which can maintain the desired level of control over the motor 105. In some examples the control signals may be used to control other components that are powered by a multi-phase inverter 108.

In some embodiments, the measurement apparatus 102 is configured to provide a predicted current measurement (not shown) to the control block 202 to substitute the current measurement 104, 204 for the phase that is experiencing the measurement failure. In some examples, the predicted current measurement can be determined based, at least in part, on the current measurements 204 for each phase not experiencing the measurement failure. In one or more examples, the predicted current measurement can be based on the phase of the current measurements that are non-faulty and predetermined information indicative of the relative phase relationship between them.

For example, for a three phase system (with phases A, B and C), if the current measurement, Ia, of phase A is identified as being faulty, but the measured currents Ib and Ic are correct (current for phase B and phase C respectively), a substituted Ia may be provided by the apparatus. Therefore, a correct value of the current for phase A can be determined based on the measured currents Ib and Ic. The relationship Ia + Ib + Ic = 0, can be rearranged to determine Ia based on the Ib and Ic measurements.

An empirical mode decomposition (EMD) can decompose the difference between $d(t)$ and $\hat{d}(t)$ into harmonics and identify which sensor of the current sensors 106A-C has failed and is providing an incorrect measurement.

In some examples the disturbance-function is calculated by step 2 of the following method.

Below is a description of a specific implementation of the measurement apparatus 102 in which the comparison module 212 can run the following steps:

Step 1: continuously compute the following equation: $I_A + I_B + I_C = ?$

If = 0 then there is no fault and no action is required

If $\neq$ 0 then there is a fault and the comparison module 212 can start the subsequent steps (Step 2 and Step 3)

The advantage of step 1 is to avoid false detection based on the result of $d(t) - \hat{d}(t)$ that is caused by some functional disturbance (e.g. electromagnetic, temperature, vibration, noises ...), the UIO method and EMD results are checked only if the condition "Ia + Ib + Ic = 0" is not satisfied and thus there is known to be an error in the current measurement.

Step 2: Compute the disturbance-function minus the disturbance-estimate

$$(d(t) - \hat{d}\ (t) = -(CN^{-1}F)^{-1}.CN^{-1}.[\dot{x}(t) - \hat{x}(t)])$$

Step 3: Run an empirical mode decomposition (EMD) to analyse the components of d(t) - $\hat{d}$ (t). Subsequent analysis of the harmonics will permit identifying the type of fault that has occurred.

In some examples the results of the above equations can be used to determine the nature of the fault and may include identifying the fault as one or more of the following:

If = EMD ($d_i - \hat{d}_i$) has more Intrinsic Mode Functions (IMFs) than healthy mode then Noise fault detected;

If = EMD ($d_i - \hat{d}_i$) has no Intrinsic Mode Functions (IMFs) then signal lost fault detected;

If = EMD ($d_i - \hat{d}_i$) gave a residual signal with an offset in comparison to the healthy residual then OFFSET failure is detected;

If = EMD ($d_i - \hat{d}_i$) has residual signal that is presenting a gain regarding the healthy profile of the residual then Gain failure is detected;

If = EMD ($d_i - \hat{d}_i$) has residual signal that is drifting from the initial drift function (when system is healthy) then drift failure is detected;

If = EMD ($d_i - \hat{d}_i$) has given a residual signal that converges after a delay in comparison to the healthy function then a delay failure is detected.

In the above i represents the component due to phase i. Thus, i=a for phase A and i=b for phase B and i=c for phase C.

It will be appreciated that in addition to the above list of possible empirical mode decomposition values, further values may be determined which can correlate to other failure modes.

Step 4: After detection of the faulty current measurement and the identification of the failure type, the comparison module 212 can provide the control block 202 with instructions to ignore the current measurement coming from the identified faulty sensor (one of 106A, 106B and 106C). The control block 202 may then be configured to use only the remaining correct current measurements 204 from the non-faulty sensors to provide accurate control to the motor 105.

According to a second aspect there is provided a system (not shown) comprising the measurement apparatus 102, the inverter 108, and a control block 202 for controlling the invertor 108.

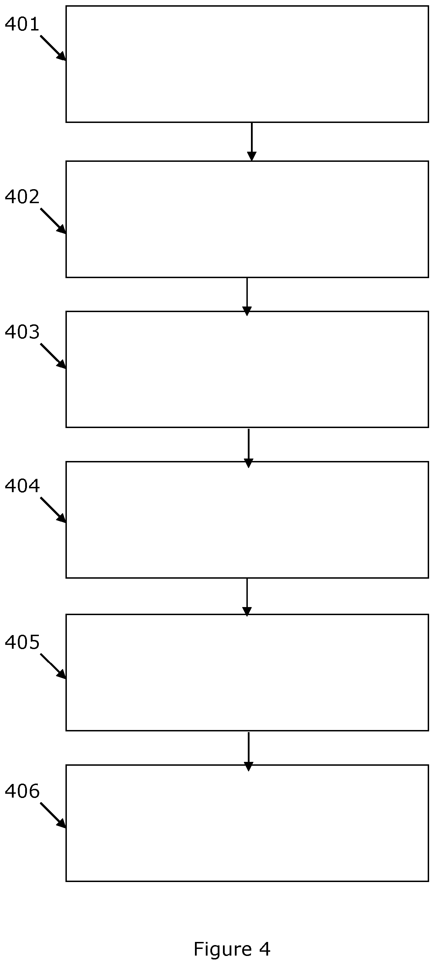

Figure 4 shows a flowchart illustrating an example method. The method comprising:

receiving 401 current measurements for each phase of a plurality of phases output by an inverter; and

receiving 402 the current measurement for each phase at a first time;

receiving 403 at least two inverter control signals that are for control of the output of the inverter at the first time;

calculating 404 a disturbance-estimation indicative of the impact of a measurement failure on the current measurements for each phase, the disturbance-estimation based on the current measurement for each phase at the first time and the at least two inverter control signals and calculated using an Unknown Input Observer, UIO, method; and receiving 405 the current measurement for each phase at a future, second time;

identifying 406 which of the plurality of phases is experiencing a measurement failure in the current measurement for that phase based on the current measurements for each phase at the second time and the disturbance-estimation.

In particular, the method includes determining a difference between a disturbance function of the UIO method, based on the current measurement, and the disturbance-estimation of the UIO method.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1.  A measurement apparatus comprising:

    an input configured to receive current measurements for each phase of a plurality of phases output by an inverter; and
    an estimator block configured to:

       receive the current measurement for each phase at a first time;
       receive at least two inverter control signals that are for control of the output of the inverter at the first time;
       calculate an disturbance-estimation indicative of the impact of a measurement failure on the current measurements for each phase, the disturbance-estimation based on the current measurement for each phase at the first time and the at least two inverter control signals and calculated using an Unknown Input Observer, UIO, method; and

    a comparison block configured to:

       receive the current measurement for each phase at a future, second time;

identify which of the plurality of phases is experiencing a measurement failure in the current measurement for that phase based on the current measurements for each phase at the second time and the disturbance-estimation.

2. The measurement apparatus of claim 1, wherein the measurement apparatus is configured to determine a sum of the current measurement for each phase at the second time and said identification of which of the plurality of phases is experiencing the measurement failure is provided in response to a determination that said sum is not equal to zero.

3. The measurement apparatus of claim 1 or claim 2, wherein the measurement apparatus is configured to operate with a control block, the control block configured to generate the at least two control signals to control one or both of the inverter and a motor that is powered by the plurality of phases output by the inverter, wherein said control signals are based at least in part on the current measurements for each phase, and
wherein the measurement apparatus is configured to, in response to said identification of which of the plurality of phases is experiencing the measurement failure, provide the control block with instructions to ignore the current measurement of the phase that is experiencing the measurement failure in generation of the control signals.

4. The measurement apparatus of claim 3 wherein the measurement apparatus is configured to provide a predicted current measurement to the control block to substitute the current measurement for the phase that is experiencing the measurement failure, the predicted current measurement determined based, at least in part, on the current measurements for each phase not experiencing the measurement failure.

5. The measurement apparatus of any preceding claim, wherein said identification of which of the plurality of phases is experiencing a measurement failure comprises the comparison block being configured to calculate a disturbance-function, comprising a function of each phase and using the UIO method, based on the current measurements for each phase at the second time, compare the disturbance-function to the disturbance-estimation, which includes components for each phase, and, based on a difference between the disturbance-function and the disturbance-estimation being greater than a threshold, identify the phase experiencing the measurement failure.

6. The measurement apparatus of any preceding claim, wherein the disturbance-estimation $\dot{\hat{d}}(t)$ is calculated by:

$$\dot{\hat{d}}(t) = inv(C.D).(\dot{y}(t) - C.A.\hat{x}(t) - C.B.u(t))$$

wherein C is an observation matrix, A, B and D are matrices that model a system comprising the invertor and a control block that provides the at least two inverter control signals, $\dot{y}(t)$ is a derivative of the output of the system, and $\hat{x}(t)$ is the estimated state vector of the system and $u(t)$ is an input vector based on the inverter control signals.

7. The measurement apparatus of any preceding claim, including a plurality of current sensors, wherein the current measurement for each phase of the plurality of phases output by the inverter is provided by the plurality of current sensors each current sensor associated with a corresponding phase of the plurality of phases output by the inverter.

8. The measurement apparatus of claim 5, wherein the comparison module is configured to, based on an empirical mode decomposition of the difference, determine one or more harmonics to identify which current measurement is providing an incorrect measurement.

9. The measurement apparatus of claim 8, wherein the comparison block is further configured to analyse the harmonics to determine a failure type associated with the current sensor of the plurality of current sensors associated with the phase of the inverter that is experiencing the measurement failure.

10. The measurement apparatus of claim 9, wherein the failure type is one or more of:
noise fault, signal loss fault, offset failure, gain failure, drift failure or a delay failure.

11. The measurement apparatus of any preceding claim, wherein the at least two inverter control signals for control of the output of the inverter comprise one of direct-quadrature-zero signals or $\alpha,\beta$ control signals of a Clark transformation.

12. The measurement apparatus of claim 7, wherein said measurement failure is indicative of a failure in one or more of said current sensors.

13. A system comprising the measurement apparatus of any preceding claim, the inverter, and the control block for controlling the invertor.

14. A method for determining which of a plurality current measurements of a corresponding plurality of phases output by an inverter is experiencing a measurement failure, the method comprising:

receiving current measurements for each phase of a plurality of phases output by an inverter at a first time;
receiving at least two inverter control signals that are for control of the output of the inverter at the first time;
calculating a disturbance-estimation indicative of the impact of a measurement failure on the current measurements for each phase, the disturbance-estimation based on the current measurement for each phase at the first time and the at least two inverter control signals and calculated using an Unknown Input Observer, UIO, method; and
receiving the current measurement for each phase at a future, second time;
identifying which of the plurality of phases is experiencing a measurement failure in the current measurement for that phase based on the current measurements for each phase at the second time and the disturbance-estimation.

15. The method of claim 14, wherein the method includes determining a difference between a disturbance-function of the UIO method, based on the current measurements, and the disturbance-estimation of the UIO method and wherein the identifying of which of the plurality of phases is experiencing a measurement failure is based on the difference.

Figure 1

200

218

214

216

220

212

208

210

102

204

206

202

204

105

106A

106B

106C

108

106

Figure 2

300

Figure 3

401 →

402 →

403 →

404 →

405 →

406 →

Figure 4

Europäisches
Patentamt

European
Patent Office

Office européen
des brevets

# EUROPEAN SEARCH REPORT

Application Number

EP 23 30 6480

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KR 2021 0075479 A (UNIV NAT HANBAT IND ACAD COOP FOUND [KR]) 23 June 2021 (2021-06-23) * paragraph [0006] - paragraph [0015]; figures 2-6 * | 1-15 | INV. G01R31/42 |
| Y | GUEZMIL AMAL ET AL: "Observer-based inter-turn short-circuit fault detection in closed-loop controlled induction machine", 2017 INTERNATIONAL CONFERENCE ON ENGINEERING & MIS (ICEMIS), IEEE, 8 May 2017 (2017-05-08), pages 1-6, XP033308485, DOI: 10.1109/ICEMIS.2017.8273075 [retrieved on 2018-01-29] * the whole document * | 1-15 | |
| Y | US 2004/239272 A1 (SCHULZ STEVEN E [US] ET AL) 2 December 2004 (2004-12-02) | 1-4,7-15 | |
| A | * paragraph [0020] - paragraph [0032]; figures 1-9 * | 5,6 | |
| A | LIU TIAN-HUA ET AL: "Fault-tolerant matrix-converter-controlled IPMSM-drive system using a predictive controller and sliding-mode estimator", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, vol. 2019, no. 11, 1 November 2019 (2019-11-01), pages 8225-8235, XP006084619, DOI: 10.1049/JOE.2019.0084 * the whole document * | 1-15 | TECHNICAL FIELDS SEARCHED (IPC) G01R G05B |

-/--

The present search report has been drawn up for all claims

| Place of search | Date of completion of the search | Examiner |
|---|---|---|
| Munich | 18 April 2024 | Ako, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Application Number

EP 23 30 6480

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2017/282968 A1 (KEZOBO ISAO [JP] ET AL) 5 October 2017 (2017-10-05) * the whole document * ----- | 1-15 | |

TECHNICAL FIELDS SEARCHED     (IPC)

The present search report has been drawn up for all claims

| Place of search | Date of completion of the search | Examiner |
|---|---|---|
| Munich | 18 April 2024 | Ako, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..............................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 30 6480

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2024

| Patent document cited in search report | | | Publication date | Patent family member(s) | | | Publication date |
|---|---|---|---|---|---|---|---|
| KR 20210075479 | A | | 23-06-2021 | NONE | | | |
| US 2004239272 | A1 | | 02-12-2004 | CN | 1833354 | A | 13-09-2006 |
| | | | | US | 2004239272 | A1 | 02-12-2004 |
| | | | | WO | 2004109895 | A2 | 16-12-2004 |
| US 2017282968 | A1 | | 05-10-2017 | CN | 107078681 | A | 18-08-2017 |
| | | | | EP | 3217537 | A1 | 13-09-2017 |
| | | | | JP | 6316449 | B2 | 25-04-2018 |
| | | | | JP | WO2016071949 | A1 | 27-04-2017 |
| | | | | US | 2017282968 | A1 | 05-10-2017 |
| | | | | WO | 2016071949 | A1 | 12-05-2016 |

EPO FORM P0459

For more details about this annex : see Official Journal of the European Patent Office, No. 12/82